# EUROPEAN PATENT APPLICATION

(11) **EP 3 872 837 A1**
(43) Date of publication of application: **01.09.2021**
(21) Application number: 20159344.9
(22) Date of filing: 25.02.2020
(51) Int. Cl.: H01J 37/141

(54) **POLE PIECE FOR AN ELECTRON MICROSCOPE**

(71) Applicant: The Provost, Fellows, Scholars and other Members of Board of Trinity College Dublin, Dublin 2 (IE)
(72) Inventor: Jones, Lewys, Dublin 2 (IE); O'Mahony, David, Dublin 2 (IE)
(74) Representative: Purdylucey Intellectual Property

(57) **Abstract**

A pole piece for an electron microscope, the pole piece comprising an upper pole piece, containing a first pathway for an electron beam, a lower pole piece which is coupled to the upper pole piece and which contains a second pathway operatively connected to the first pathway, the upper pole piece and lower pole piece being separated by a gap between the first pathway and the second pathway. The pole piece has a mechanism which can extend or reduce the distance between the upper pole piece and the lower pole piece by changing the distance between the first pathway and the second pathway.

## Description

### Field

The disclosure relates to a pole piece for an electron microscope. The disclosure also relates to a pole piece for use in charged particle devices, such as electron-beam lithography instruments (EBL), e-beam sterilisation instruments, or e-beam 3D-printers and the like.

### Background

An electron microscope is a microscope that uses a beam of accelerated electrons as a source of illumination. As the wavelength of an electron can be up to 100,000 times shorter than that of visible light photons, electron microscopes have a higher resolving power than light microscopes and can reveal the structure of smaller objects.

Electron microscopes are used to investigate the ultrastructure of a wide range of biological and inorganic specimens including microorganisms, cells, large molecules, biopsy samples, metals, and crystals. Industrially, electron microscopes are often used for quality control and failure analysis.

There are a number of different types of electron-beam imaging or lithography instruments. One example is a transmission electron microscope (TEM).

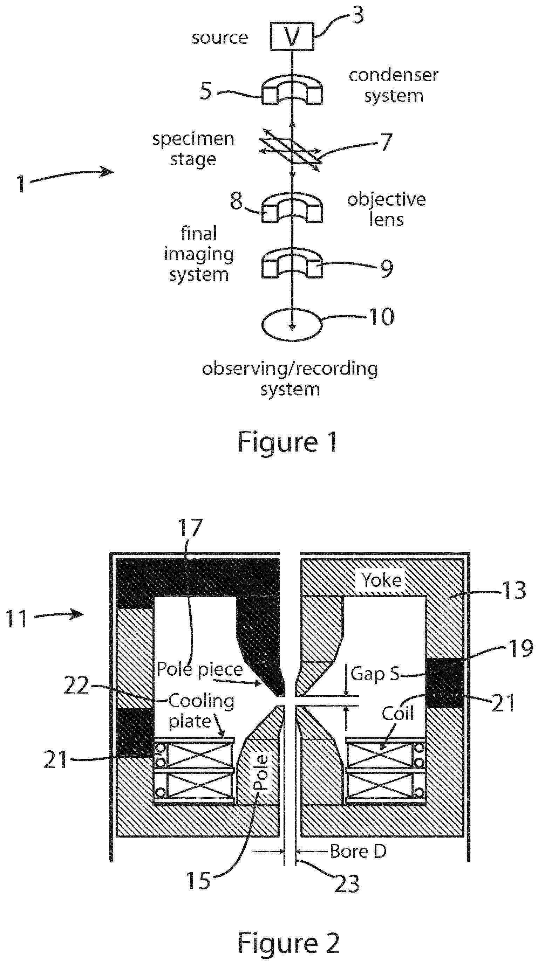

Figure 1 is a schematic diagram of a TEM 1 which shows its basic features. It comprises an electron source 3, a condenser system 5 which focuses the electron beam from the source, a specimen stage 7 where the specimen is held, an objective lens 9 which collects and focuses electrons which have been transmitted through the sample and an imaging lens which expands the beam onto an imaging device 10. The elements are all typically enclosed in a vacuum chamber. A TEM uses a high voltage to create an electron beam which is produced by an electron gun. The electron beam is accelerated by an electric field to a desired energy.

The electromagnetic lens is usually made of a solenoid coil nearly surrounded by ferromagnetic materials designed to concentrate the coil's magnetic field into a precise, confined shape. When an electron enters and leaves this magnetic field, it converges around the curved magnetic field lines in a manner similar to an optical converging lens. A magnetic lens's focusing power can be changed by adjusting the current passing through the coils. This allows a lens system, between the source and the sample (the "condenser lens" system) to produce a parallel beam over 1 millimetre in diameter, a tightly focused beam smaller than an atom, or anything in between.

The magnetic field produced for the lens should be radially symmetrical, as deviation from the radial symmetry of the magnetic lens will causes aberrations, such as chromatic or spherical aberration. Electron lenses are generally manufactured from iron, iron-cobalt or nickel cobalt alloys, such as permalloy. These are selected for their magnetic properties, such as magnetic saturation, hysteresis and permeability.

An example cross-section of part of a TEM 11 is shown in Figure 2. This part receives an incident electron beam from a condenser lens. The electromagnet comprises a yoke 13 and coils 21. The sample space comprises a pole gap 19 which is bounded by pole piece 17 mounted on the pole 15. The axially extending space 23 defines a bore which accommodates the beam-path. Control of the strength of the magnetic fields is achieved by varying the current in the coils and shapes the electron beam.

The pole piece is a magnetic pole made of a soft magnetic material (for example pure iron, Permandur, Hiperco50 or similar material) which concentrates the magnetic flux produced by the electromagnet and is guided by the yoke to produce a strong magnetic field in a narrow gap in the polepiece. Pole pieces are known for a long time in electron lens systems, for example various pole piece designs are disclosed in US3,324,433; US2,749,464; US2,472,315; US3,754,443 and US2,418,432, however none of these pole pieces are suitable for incorporation in modern electron microscopes.

The pole gap dictates the final shape of the magnetic field incident upon the sample. The geometry of an installed pole piece may be optimised for different purposes and is selected when an instrument is purchased. This configuration will then typically remain for the entire lifetime of the microscope (perhaps 20 years).

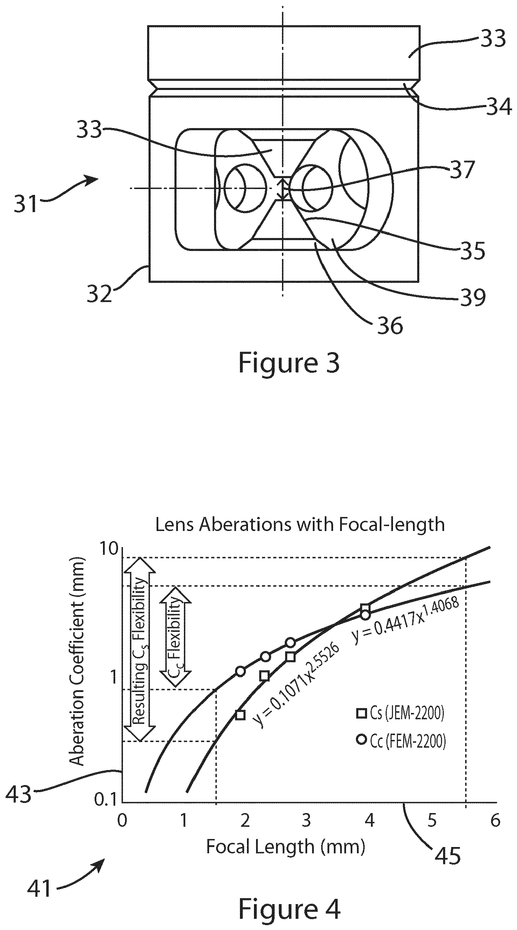

Figure 3 shows an example of a pole-piece 31, supplied by the company Jeol Inc. (https://www.jeol.co.jp/en/), which comprises an upper pole 33 positioned towards the electron source and condenser lens of the microscope and a lower pole 35. The upper pole 33 and lower pole 35 are hollow and frustoconical in shape with the poles pointing towards one another. The smaller, lower pole 35 engages with the remainder of the iron magnetic circuit via a base portion 36, while the upper (larger) pole 33 mates around its underside face 34. The opposing adjacent planes of the upper and lower pole are separated by a fixed gap 37. The upper and lower poles 33, 35 are held at a fixed separation by a supporting frame 32 made from some non-magnetic material. This frame may include ports 39 for various access requirements.

Figure 4 is a known graph 41 which plots the spherical and chromatic aberration coefficients 43 (the two dominant optical defects in these systems) against the focal length 45 of various available pole-pieces, supplied by www.jeoi.co.jp/en/. Because of unavoidable physical limitations to the shaping of magnetic fields, the optical quality of electron lenses scales with their focal length which itself scales with the pole-piece gap size.

For example, a microscopist purchasing a new state-of-the-art TEM (at a cost of around €4-5M) may select a small-gap ultra-high-resolution pole-piece (UHR), an intermediate resolution (HR) pole-piece, or a so-called 'analytical' (ARP) with a larger gap. Selection of the configuration of a pole piece may be made to, for example, provide maximum image resolution (a smaller gap size and focal length) or to maximum chemical mapping sensitivity (using a larger gap size to allow closer approach of spectrometers or mirrors), but these features of the output cannot both be maximised for a single pole piece configuration. As a result, an Ultra-high-resolution (UHR) pole-piece is required for the microscope to deliver on its ultimate resolution potential but this severely limits the potential for x-ray spectroscopic collection. The analytical-resolution pole-piece (ARP) on the other hand allows for better chemical spectroscopy and greater tilting or a wider range of in-situ experiments, but at the cost of some lost resolution.

In principle it would be possible for a customer to request the manufacturer to exchange the pole-piece on a modern-generation TEM, but this can incur a downtime of around one month per change and great associated expense.

It is an object of the present invention to create a pole piece for an electron microscope which addresses the above problems.

### Summary of the Invention

In accordance with a first aspect of the invention there is provided, as set out in the appended claims, a pole piece for an electron microscope, the pole piece comprising:
an upper pole piece, containing a first pathway for an electron beam,
a lower pole piece which is coupled to the upper pole piece and which contains a second pathway operatively connected to the first pathway, the upper pole piece and lower pole piece being separated by a gap between the first pathway and the second pathway,
wherein the pole piece comprises a mechanism which can extend or reduce the distance between the upper pole piece and the lower pole piece by changing the distance between the first pathway and the second pathway.

An important advantage of the pole piece of the present invention is that the spacing between the upper and lower pole piece can be adjusted whilst under vacuum using the mechanism. Additionally, different samples can be introduced for inspection using the microscope with minimum effort.

In at least one embodiment, the mechanism adjusts the position of the upper pole piece.

In at least one embodiment, the mechanism moves the upper pole piece towards or away from the lower pole piece whilst maintaining a common axis.

In at least one embodiment, the upper pole piece comprises an outer part with a concentrically mounted inner part.

In at least one embodiment, the inner part is coupled to the mechanism and is moveable to extend or reduce the distance between the upper pole piece and the lower pole piece.

In at least one embodiment, the mechanism comprises a bearing mounted between a sleeve, the sleeve formed from an inner concentric surface of the outer part and an outer concentric surface of the concentrically mounted inner part.

In at least one embodiment, the bearing is actuated by a rotatable cam with the bearing acting as the follower which experiences linear motion.

In at least one embodiment, the bearing and sleeve have cooperating threads which allow the bearing to be rotated and moved in linearly.

In at least one embodiment, the mechanism comprises:
a spacer which couples the outer part of the upper pole piece to the lower pole piece;
an anulus rotatably mounted in a substantially circular channel between the outer part and the inner part of the upper pole piece and connected to an actuator wherein rotation of the annulus causes the actuator to move the inner part to extend or reduce the distance between the upper pole piece and the lower pole piece.

In at least one embodiment, the actuator comprises an inclined ratchet and pawl mechanism.

In at least one embodiment, the mechanism is rotatable in one direction, clockwise or anticlockwise. As the mechanism only rotates in one direction means that pole piece 'locks' into position without any external clamping or braking required.

In at least one embodiment, the inclined ratchet comprises a stepped surface of the outer part of the upper pole piece and the pawl comprises an engaging lower surface of the annulus.

In at least one embodiment, the stepped surface comprises a bottom surface of the channel and the pawl comprises a lower surface of the annulus.

In at least one embodiment, the height of the steps on the stepped surface define discrete values of the size of the distance between the upper pole piece and the lower pole piece and therefore, the gap between the first channel and the second channel.

In at least one embodiment, the annulus includes three pawls. An advantage of having three pawls is that it produces a stable and repeatable positioning to adjust the distance between the upper and lower pole piece.

In at least one embodiment, the step heights define a gap between the upper pole piece end and lower pole piece end of 1.5mm, 4.0mm and 6.5mm respectively.

In at least one embodiment, there are five steps which define a gap between the upper pole piece end and lower pole piece end in increments of 1.25mm from a smallest gap of 1.5mm to a largest gap of 6.5mm. Suitably five steps can be provided spaced at 1.5mm, 2.75mm, 4.0mm, 5.25mm, and 6.5mm.

In at least one embodiment of the present invention, the inner part of the upper pole piece comprises a hollow centred generally cylindrical body having a flange for engagement with the anulus at one end with a frustoconical second end which narrows to meet the pole end of the lower pole piece.

In at least one embodiment, a drive mechanism is used to rotate the annulus.

In at least one embodiment, the drive mechanism comprises a set of gear teeth mounted on its outer circumference of the annulus which are operatively connected to one or more cog which couples the annulus to a drive shaft.

In at least one embodiment, the drive shaft is manually operable.

In at least one embodiment, the drive shaft is machine operable.

In at least one embodiment, a feedback mechanism is provided to note the position of, or number of revolutions of, the drive shaft such that the separation of the upper and lower pole pieces is known. Suitably the distance between the upper and pole piece can be visually displayed. The visual display can be a numerical value or colour indicator.

In at least one embodiment, a switch/trigger monitors the position of the upper and/or lower pole piece.

In at least one embodiment, access is provided for a camera or similar device to observe the position of the upper and/or lower pole piece.

### Brief Description of the Drawings

The invention will be more clearly understood from the following description of an embodiment thereof, given by way of example only, with reference to the accompanying drawings, in which:
Figure 1 is a schematic diagram of a TEM as generally known;
Figure 2 is a schematic cross-section of a symmetrical objective-lens of a TEM including a known pole piece;
Figure 3 is a perspective view of a known fixed gap pole piece;
Figure 4 is a graph which plots the aberration coefficient 43 against the focal length of the spherical and chromatic aberrations;
Figures 5a and 5b are schematic representations of a first embodiment of the present invention;
Figure 6 is a cut away perspective view of a second embodiment of the present invention;
Figure 7 is a perspective view of the second embodiment of the present invention;
Figure 8 is a perspective view of the second embodiment of the present invention;
Figures 9a to 9c are side views of the second embodiment of the present invention which show differing gap heights;
Figure 10 is a graph which plots optical axis distance against magnetic flux density for a 1.5mm pole piece gap;
Figure 11 is a graph which plots optical axis distance against magnetic flux density for a 4.5mm pole piece gap; and
Figure 12 is a graph which plots optical axis distance against magnetic flux density for a 6.5mm pole piece gap.

### Detailed Description of the Drawings

The present invention provides a pole piece for a transmission electron microscope (TEM) which allows the pole piece gap, that is, the gap between the upper pole piece and the lower pole piece to be adjusted without the cost in time and money of disassembling the TEM to replace the pole piece with one having a different sized pole piece gap. Moreover the pole piece of the present invention can work in a vacuum when incorporated into a transmission electron microscope. In other words the upper pole piece and the lower pole piece can be adjusted in a vacuum.

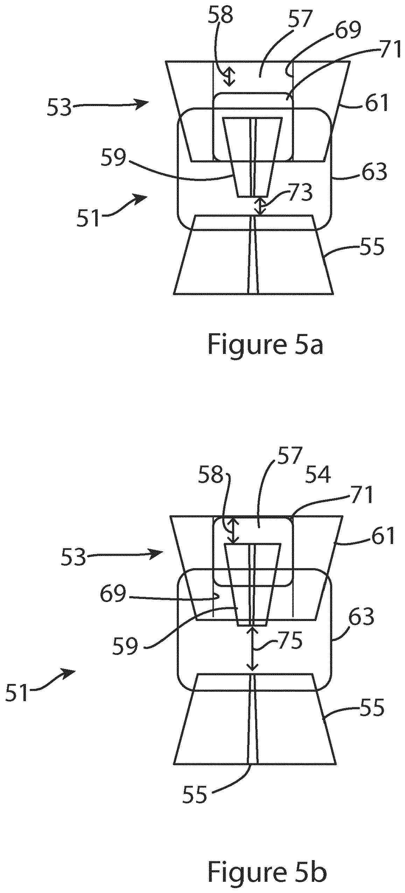

Figures 5a and 5b are schematic diagrams which show a pole piece 51 which has an upper pole piece (UPP) 53 and a lower pole piece (LPP) 55. Pathway inside the UPP 53 illustrates the cavity running the length of the UPP 43 at its centre where the magnetic field is concentrated. The pathway and magnetic field focusses the electrons as they travel from the TEM's electron source to its specimen stage (not shown). A similar pathway 56 is shown in the LPP for electrons once transmitted from the specimen towards the objective and imaging lenses.

In this example of the present invention a mechanism for linear movement of the UPP 53 comprises a carriage or bearing 71 which is positioned between an outer part 61 of the UPP 53 and an inner part 59. The inner part 59 and the outer part 61 are concentric, the centre of the pathway being aligned with the centre of the UPP 53. The bearing is mounted in a sleeve 69 which forms an inner concentric surface of the outer part 61. Spacer 63 fixedly connects the outer part 61 of the UPP 53 to the LPP 55. The inner part 59 is not so connected and may move linearly as shown by arrow 58 to and from the pole end of the LPP 55.

The carriage or bearing 71 may be actuated in a number of ways, for example a small cam may be mounted on the bearing which may be resiliently mounted such that rotation of the cam will cause linear movement of the bearing which will move the inner part 59 of the UPP 53 linearly as shown by arrow 58. Alternatively, the bearing 71 and sleeve 69 may have cooperating threads which allow the bearing to be rotated and moved in direction 58.

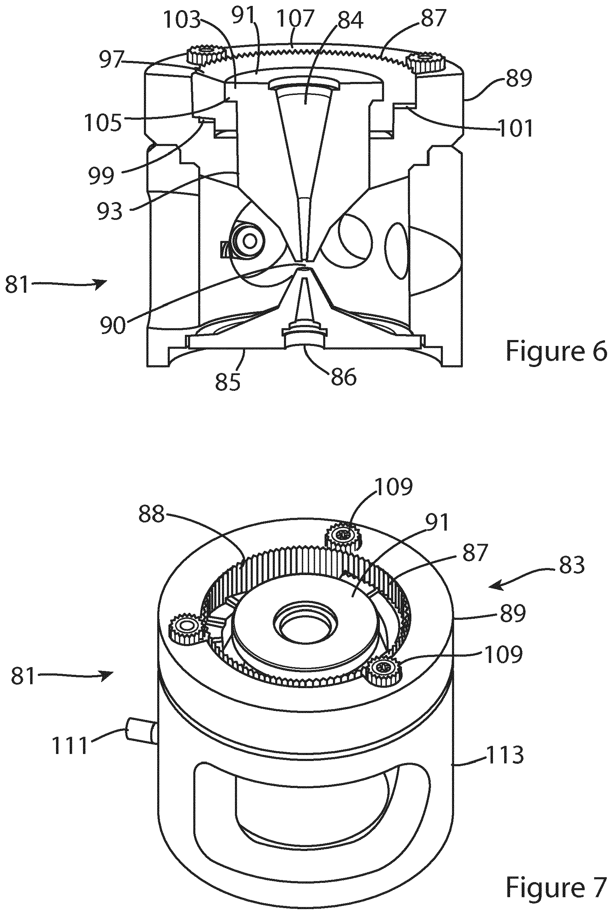

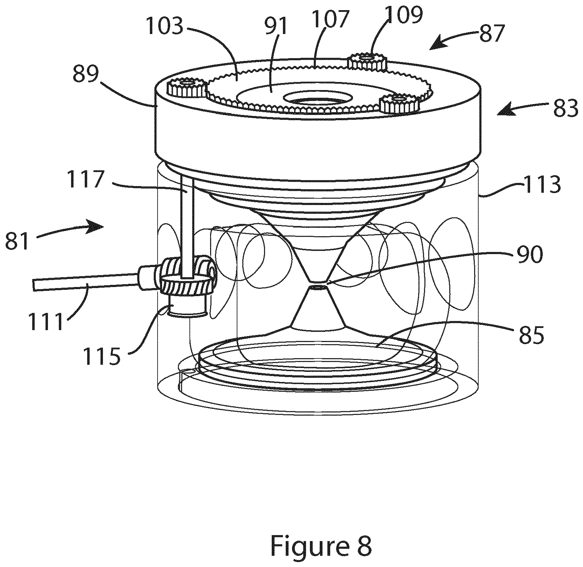

Figures 6 to 9 show a second and preferred embodiment of the present invention. In figures 6 to 9 reference the same numerals are used to describe the same features when illustrated in different drawings.

Figures 6 to 9 show a pole piece 81 which has an upper pole piece (UPP) 83 and a lower pole piece (LPP) 85. Pathway 84 inside the UPP illustrates the cavity running the length of the UPP at its centre where the magnetic field is concentrated. A similar pathway 86 is shown in the LPP for electrons once transmitted from the specimen towards the objective and imaging lenses. Pathways 84 and 86 are accurately aligned to allow the electrons to pass through to the objective lens.

In this example, the UPP comprises an outer part 89 and an inner part 91. The outer pole part 89 is supported by a spacer 113 which connects it to the LPP 85. The inner part 91 comprises a hollow centred generally cylindrical body having a flange 105 for engagement with a coupling ring or anulus 97 at one end with a frustoconical second end which narrows to meet the pole end of the lower pole piece 85 at the gap 90. The cylindrical surface of the inner part 91 is slidable connected to the outer part 89 at surface 93.

The coupling ring 97 couples the inner part 91 to a drive mechanism. The outer circumference of the ring 97 has gear teeth 107 which are operatively connected to toothed cogs 109 which, in turn are connected to a gear shaft 117, worm gear 115 and drive shaft 111. It will be appreciated that only one of the three cogs 109 can be is connected to the drive shaft. The other two cogs are free rotating and are used to stabilise the toothed ring.

The coupling ring 97 has a tiered bottom surface and is located in a channel 88 which comprises a tiered upwardly pointing surface 98 of the outer UPP 89. The top tier of the upwardly pointing surface 98 comprises an inclined stepped surface, that is, the size of the step increases around the circumference of the channel. As is apparent from figure 6, step 101 is larger than step 99. The cooperative engagement between the tiered bottom surface of the ring and the steps acts to change the distance between the inner UPP 91 and the LPP 85 upon rotation of the ring. The stepped shape also acts to prevent contra-rotation of the ring 97, in other words, the inner UPP 91 is engaged on an inclined ratcheting plane so as to lift when rotated. This lifting is then released and the inner portion locks into a new raised position.

The design achieves the required rotation and lifting of the inner UPP 85 using the gear shaft 117 to translate mechanical motion via the worm gear 115 from the external drive shaft 111. A feedback mechanism (not shown) can be provided to cooperate with the drive shaft 111 or gear shaft 117 to note the position of, or number of revolutions of, the drive shaft such that the separation of the upper and lower pole pieces is known. Suitably the distance between the upper and pole piece can be visually displayed. The visual display can be a numerical value or colour indicator. For example, a numerical counter can be used to display the position of the upper and lower pole pieces with respect to each other. A switch/trigger can be provided to monitor the position of the upper and/or lower pole piece. It will be appreciated that the pole piece can be dimensioned to allow access by a camera or other viewing device to visually inspect the pole piece.

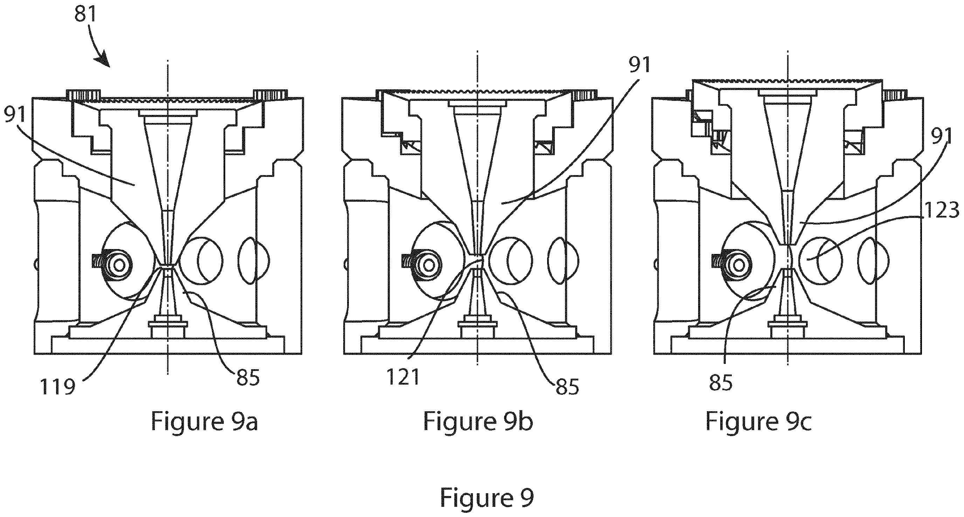

Figures 9a to 9c show an enlargement of the central portion of the adjustable pole-piece 81 as shown in the embodiment of figures 6 to 8.

Figure 9a shows the pole piece 81, with an inner UPP 91, ratchet surface 98 in the channel 88 of the outer UPP 89. Pathways 84 and 86 are accurately aligned to allow the electrons to pass through to the objective lens. In this example, the mechanism moves the inner UPP to set a gap 119 of 1.5mm to the LPP 85.

Figure 9b shows the pole piece 81, with an inner UPP 91, ratchet surface 98 in the channel 88 of the outer UPP 89. Pathways 84 and 86 are accurately aligned to allow the electrons to pass through to the objective lens. In this example, the mechanism moves the inner UPP to set a gap 121 of 4.0mm to the LPP 85.

Figure 9c shows the pole piece 81, with an inner UPP 91, ratchet surface 98 in the channel 88 of the outer UPP 89. Pathways 84 and 86 are accurately aligned to allow the electrons to pass through to the objective lens. In this example, the mechanism moves the inner UPP to set a gap 123 of 6.5mm to the LPP 85.

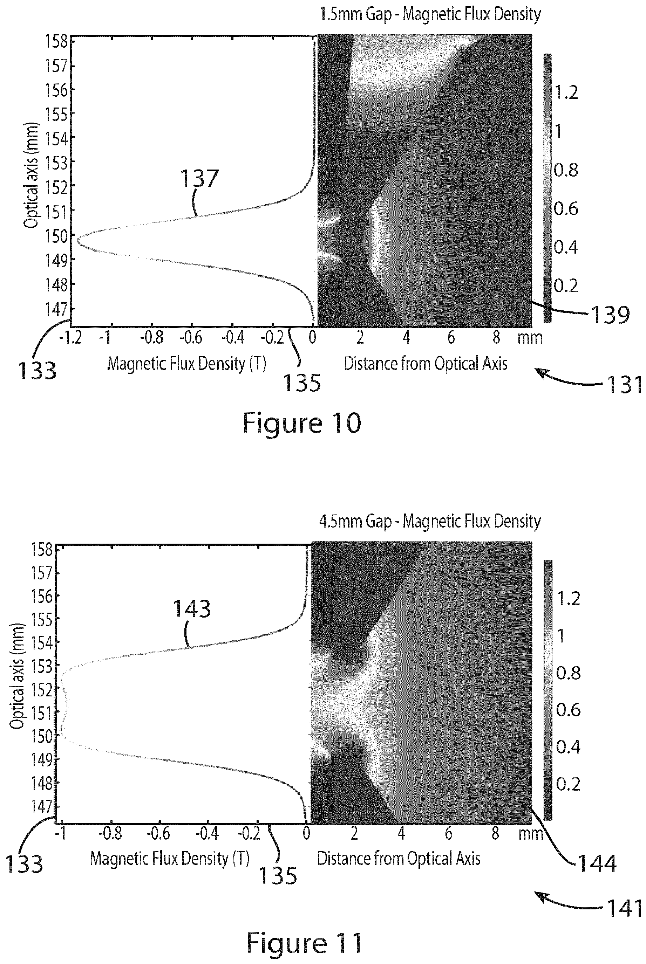

Figure 10 is a graph 131 of optical axis distance 133 against magnetic flux density 135 for a 1.5mm pole piece gap. The curve 137 is a gaussian curve with a single peak. The intensity distribution as a function of the distance from the optical axis 139 is also shown.

Figure 11 is a graph 141 which plots optical axis distance against magnetic flux density for a 4.5mm pole piece gap. The curve 143 is a gaussian curve with a narrow double peak. The intensity distribution as a function of the distance from the optical axis 149 is also shown.

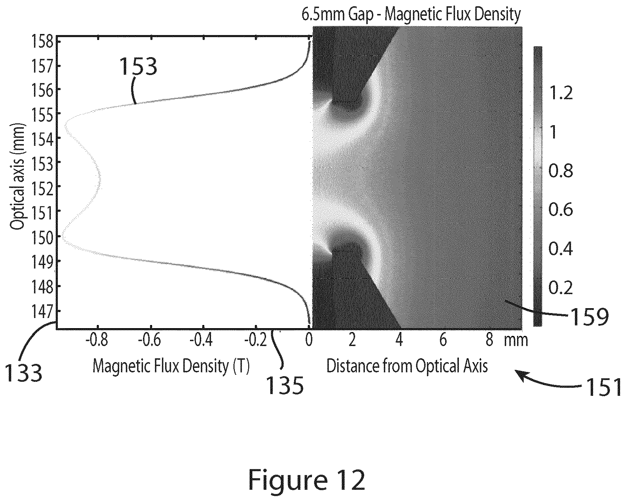

Figure 12 is a graph 151 which plots optical axis distance against magnetic flux density for a 6.5mm pole piece gap. The curve 153 is a gaussian curve with a wide double peak. The intensity distribution as a function of the distance from the optical axis 159 is also shown.

In general, a single peak with a sharp Gaussian distribution of magnetic flux density with respect to optical axis distance would be considered to be an ideal lens, whereas at the more expanded setting the optical quality is poorer but allows a spectrometer to be closer to the sample or larger sample tilts.

In the specification the terms "comprise, comprises, comprised and comprising" or any variation thereof and the terms include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A pole piece for an electron microscope, the pole piece comprising:
an upper pole piece, containing a first pathway for an electron beam,
a lower pole piece which is coupled to the upper pole piece and which contains a second pathway operatively connected to the first pathway, the upper pole piece and lower pole piece being separated by a gap between the first pathway and the second pathway,
wherein the pole piece comprises a mechanism which can extend or reduce the distance between the upper pole piece and the lower pole piece by changing the distance between the first pathway and the second pathway.

2. The pole piece as claimed in claim 1 wherein the mechanism adjusts the position of the upper pole piece.

3. The pole piece as claimed in claim 1 or claim 2 wherein, the mechanism moves the upper pole piece towards or away from the lower pole piece.

4. The pole piece as claimed in any preceding claim wherein, the upper pole piece comprises an outer part with a concentrically mounted inner part.

5. The pole piece as claimed in claim 4 wherein, the inner part is coupled to the mechanism and is moveable to extend or reduce the distance between the upper pole piece and the lower pole piece.

6. The pole piece as claimed in any preceding claim wherein, the mechanism comprises a bearing mounted between a sleeve, the sleeve formed from an inner concentric surface of the outer part and an outer concentric surface of the concentrically mounted inner part.

7. The pole piece as claimed in claim 6 wherein, the bearing is actuated by a rotatable cam with the bearing acting as the follower which experiences linear motion.

8. The pole piece as claimed in claim 6 wherein, the bearing and sleeve have cooperating threads which allow the bearing to be rotated and moved linearly.

9. The pole piece as claimed in claims 1 to 5 wherein, the mechanism comprises:
a spacer which couples the outer part of the upper pole piece to the lower pole piece;
an anulus rotatably mounted in a substantially circular channel between the outer part and the inner part of the upper pole piece and connected to an actuator wherein rotation of the annulus causes the actuator to move the inner part to extend or reduce the distance between the upper pole piece and the lower pole piece.

10. The pole piece as claimed in claim 9 wherein, the actuator comprises an inclined ratchet and pawl mechanism.

11. The pole piece as claimed in claim 10 wherein, the inclined ratchet comprises a stepped surface of the outer part of the upper pole piece and the pawl comprises an engaging lower surface of the annulus.

12. The pole piece as claimed in claim 11 wherein, stepped surface the stepped surface comprises a plurality of steps, the height of the steps on the stepped surface define discrete values of the size of the distance between the upper pole piece and the lower pole piece and therefore, the gap between the first channel and the second channel.

13. The pole piece as claimed in any preceding claim wherein, a drive mechanism is used to rotate the annulus.

14. The pole piece as claimed in claims 9 to 13 wherein, the drive mechanism comprises a set of gear teeth mounted on its outer circumference of the annulus which are operatively connected to one or more cog which couples the annulus to a drive shaft.

15. The pole piece as claimed in any preceding claim comprising a feedback mechanism to note the position of, or number of revolutions of, the drive shaft such that the separation of the upper and lower pole pieces is known.
